(19) Europäisches Patentamt / European Patent Office / Office européen des brevets

(11) **EP 4 339 226 A1**

(12) **EUROPEAN PATENT APPLICATION**
published in accordance with Art. 153(4) EPC


(43) Date of publication:
**20.03.2024 Bulletin 2024/12**

(21) Application number: **22807480.3**

(22) Date of filing: **10.05.2022**

(51) International Patent Classification (IPC):
***C08G 65/40*** *(2006.01)* ***H05K 1/03*** *(2006.01)*

(52) Cooperative Patent Classification (CPC):
**C08G 65/40; H05K 1/03**

(86) International application number:
**PCT/JP2022/019868**

(87) International publication number:
**WO 2022/239781 (17.11.2022 Gazette 2022/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **10.05.2021 JP 2021079793**



(71) Applicants:
- **DAIKIN INDUSTRIES, LTD.**
  **Osaka-Shi, Osaka 530-0001 (JP)**
- **NATIONAL UNIVERSITY CORPORATION, IWATE UNIVERSITY**
  **Morioka-shi, Iwate 020-8550 (JP)**

(72) Inventors:
- **OISHI, Yoshiyuki**
  **Morioka-shi, Iwate 020-8550 (JP)**
- **NOGUCHI, Tsuyoshi**
  **Osaka-shi, Osaka 530-0001 (JP)**

(74) Representative: **Hoffmann Eitle**
**Patent- und Rechtsanwälte PartmbB**
**Arabellastraße 30**
**81925 München (DE)**


(54) **FLUORINE-CONTAINING POLYETHER COMPOUND**


(57) The present disclosure provides a fluorine-containing polyether compound having a repeating unit represented by formula (1).

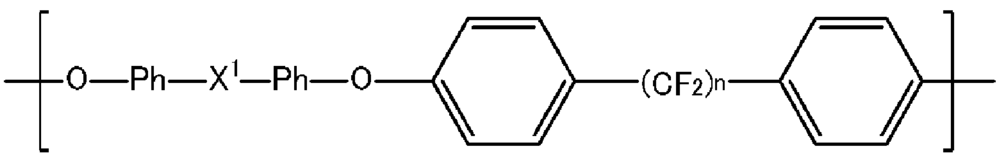

In formula (1), n represents an integer of 1 to 8, Ph represents a phenylene group, $X^1$ represents a heterocyclic ring or a hydrocarbon ring, one or both of two phenylene groups represented by Ph, and the heterocyclic ring or hydrocarbon ring represented by $X^1$ are optionally condensed with each other, and the phenylene group, the heterocyclic ring, and the hydrocarbon ring optionally have a substituent.


EP 4 339 226 A1

## Description

### TECHNICAL FIELD

The present disclosure relates to a fluorine-containing polyether compound.

### BACKGROUND ART

Non Patent Document 1 states that polymerization of 1,6-bis(4-fluorophenyl)perfluorohexane with bisphenol AF, bisphenol A, or resorcinol gives a poly(perfluoroalkylene aryl ether) having a particular structure.

### RELATED ART

### NON PATENT DOCUMENTS

Non Patent Document 1: Jeff W. Labadie, et al., "Perfluoroalkylene-Activated Poly(aryl ether) Synthesis," Macromolecules, American Chemical Society, 1990, vol. 23, No. 26, 5371-5373

### SUMMARY OF THE INVENTION

### PROBLEM TO BE SOLVED BY THE INVENTION

The glass transition temperature of poly(perfluoroalkylene aryl ethers) disclosed in Non Patent Document 1 is only 95°C at the highest. Accordingly, there is a need for a fluorine-containing polyether compound having higher heat resistance.

An object of the present disclosure is to provide a fluorine-containing polyether compound that exhibits sufficiently low dielectric constant and dielectric dissipation factor and has both significantly high glass transition temperature and high solubility.

### MEANS FOR SOLVING THE PROBLEM

The present disclosure provides a fluorine-containing polyether compound having a repeating unit represented by formula (1).

Formula (1):

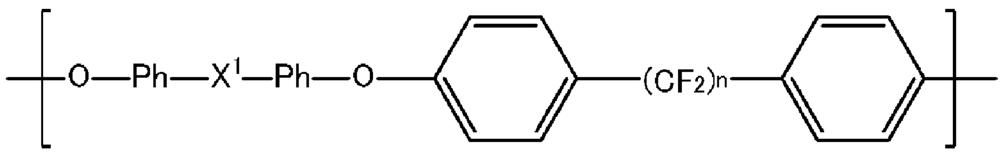

in formula (1), n represents an integer of 1 to 8, Ph represents a phenylene group, and $X^1$ represents a heterocyclic ring or a hydrocarbon ring; one or both of two phenylene groups represented by Ph, and the heterocyclic ring or the hydrocarbon ring represented by $X^1$ are optionally condensed with each other; and the phenylene group, the heterocyclic ring, and the hydrocarbon ring optionally have a substituent.

In formula (1), $X^1$ preferably represents an aromatic heterocyclic ring optionally having a substituent, an aromatic hydrocarbon ring optionally having a substituent, or an aliphatic hydrocarbon ring optionally having a substituent.

In formula (1), $X^1$ preferably represents at least one selected from the group consisting of rings represented by the following formulas.

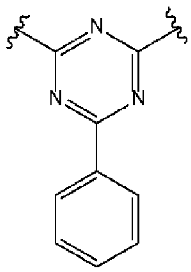 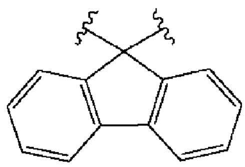 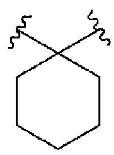 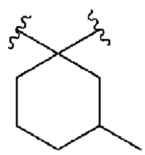 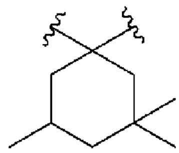

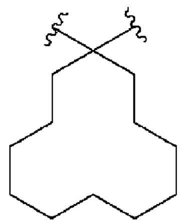 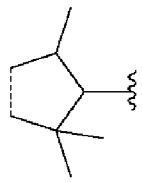

in each formula, each undulating line represents a bond position to the phenylene group represented by Ph, and a broken line represents a carbon-carbon bond shared with the phenylene group represented by Ph.

The average degree of polymerization of the repeating unit represented by formula (1) is preferably 2 to 300.

Moreover, the present disclosure provides a fluorine-containing polyether compound having a repeating unit represented by formula (2).

Formula (2):

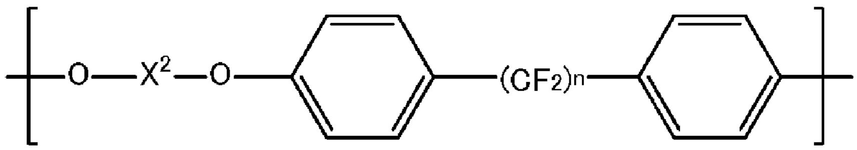

in formula (2), n represents an integer of 1 to 8, and $X^2$ represents a polycyclic aromatic hydrocarbon ring optionally having a substituent.

In formula (2), the polycyclic aromatic hydrocarbon ring is preferably at least one selected from the group consisting of a biphenyl ring, a terphenyl ring, a quaterphenyl ring, a naphthalene ring, an anthracene ring, a tetracene ring, and a pentacene ring.

The average degree of polymerization of the repeating unit represented by formula (2) is preferably 2 to 300.

Further, the present disclosure provides a low dielectric material containing the above fluorine-containing polyether compound.

Furthermore, the present disclosure may provide the present disclosure provides a semiconductor package substrate, a flexible printed circuit board, or a rigid printed circuit board containing the above fluorine-containing polyether compound.

## EFFECTS OF INVENTION

The present disclosure may provide a fluorine-containing polyether compound that exhibits sufficiently low dielectric constant and dielectric dissipation factor and has both significantly high glass transition temperature and high solubility.

## DESCRIPTION OF EMBODIMENTS

Hereinafter, specific embodiments of the present disclosure will be described in detail, but the present disclosure is not limited to the following embodiments.

A fluorine-containing polyether compound of the present disclosure has a repeating unit represented by formula (1) .

Formula (1):

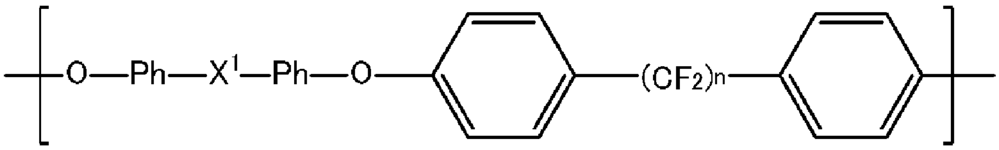

in formula (1), n represents an integer of 1 to 8, Ph represents a phenylene group, and $X^1$ represents a heterocyclic ring or a hydrocarbon ring; one or both of two phenylene groups represented by Ph, and the heterocyclic ring or the hydrocarbon ring represented by $X^1$ are optionally condensed with each other; and the phenylene group, the heterocyclic ring, and the hydrocarbon ring optionally have a substituent.

n represents an integer of 1 to 8. n is preferably an integer of 4 to 8, and is more preferably 4, 6, or 8.

Ph represents a phenylene group. In some embodiments, the phenylene group has a substituent but does not necessarily have a substituent. Examples of the substituent include halogen atoms, such as a fluorine atom; alkyl groups, such as a methyl group; and alkyl halide groups, such as a trifluoromethyl group.

$X^1$ represents a heterocyclic ring or a hydrocarbon ring. In some embodiments, the heterocyclic ring or hydrocarbon ring represented by $X^1$ is a ring having at least two bonding parts bonding to two phenylene groups; a ring having at least one bonding part bonding to at one of the two phenylene groups and at least one carbon-carbon bond shared with the other one of the two phenylene groups; or a ring having at least two carbon-carbon bonds shared with the two phenylene groups. The heterocyclic ring or hydrocarbon ring represented by $X^1$ is preferably a ring having at least two bonding parts bonding to the two phenylene groups, or a ring having at least one bonding part bonding to one of the two phenylene groups and at least one carbon-carbon bond shared with the other one of the two phenylene groups.

When the phenylene group represented by Ph and the ring represented by $X^1$ share at least one carbon-carbon bond, a structure represented by -Ph-$X^1$-Ph- includes a condensed ring formed by condensing the heterocyclic ring or hydrocarbon ring represented by $X^1$ and at least one of the phenylene groups represented by Ph. Accordingly, in the present disclosure, the phenylene group represented by Ph encompasses not only a residue produced by removing two hydrogen atoms from benzene but also a residue derived from benzene, obtained by removing one hydrogen atom from the benzene, and forming a part of a polycyclic ring by condensation with another ring. Examples of such a structure (structure represented by -Ph-$X^1$-Ph-) including a condensed ring includes a structure shown below.

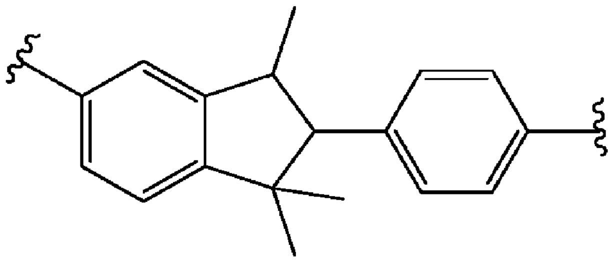

In the formula, each undulating line represents a bond position to an oxygen atom.

Among the rings represented by $X^1$, the heterocyclic ring is preferably a ring formed by carbon atoms and an atom or atoms other than a carbon atom. The atom other than the carbon atom is preferably a nitrogen atom, an oxygen atom, or sulfur atom, and more preferably a nitrogen atom. That is, the heterocyclic ring is preferably a nitrogen-containing heterocyclic ring. The number of atoms other than the carbon atom in the ring is preferably 1 to 3, and more preferably 3.

In some embodiments, the heterocyclic ring is an aliphatic heterocyclic ring or an aromatic heterocyclic ring. The heterocyclic ring is preferably an aromatic heterocyclic ring. Further, in some embodiments, the heterocyclic ring is a monocyclic ring or a polycyclic ring. The heterocyclic ring is preferably a monocyclic ring, more preferably a monocyclic aromatic heterocyclic ring, and still more preferably a monocyclic nitrogen-containing aromatic heterocyclic ring.

The number of members of the heterocyclic ring is not limited but is preferably 3 to 12, and more preferably 5 or more, and is more preferably 9 or less, and still more preferably 6 or less.

Examples of the heterocyclic ring include a furan ring, a thiophene ring, a pyrrole ring, an oxazole ring, an isoxazole ring, a thiazole ring, an isothiazole ring, an imidazole ring, a pyrazole ring, a 1,2,3-oxadiazole ring, a 1,2,4-oxadiazole ring, a 1,3,4-oxadiazole ring, a furazan ring, a 1,2,3-thiadiazole ring, a 1,2,4-thiadiazole ring, a 1,3,4-thiadiazole ring, a 1,2,3-triazole ring, a 1,2,4-triazole ring, a tetrazole ring, a pyridine ring, a pyridazine ring, pyrimidine ring, a pyrazine ring, and a triazine ring. Among others, the heterocyclic ring is preferably a 1,3,5-triazine ring.

In some embodiments, the heterocyclic ring has a substituent but does not necessarily have a substituent. Examples of the substituent include halogen atoms, such as a fluorine atom; alkyl groups, such as a methyl group; alkyl halide groups, such as a trifluoromethyl group; and aryl groups, such as a phenyl group.

In some embodiments, the hydrocarbon ring among the rings represented by $X^1$ is an aliphatic hydrocarbon ring or an aromatic hydrocarbon ring. In some embodiments, the aliphatic hydrocarbon ring is a saturated or unsaturated hydrocarbon ring not having aromaticity. In some embodiments, the hydrocarbon ring is a monocyclic ring or a polycyclic ring. In some embodiments, the polycyclic hydrocarbon ring is a condensed ring.

The carbon number of the hydrocarbon ring is preferably 3 to 30, more preferably 5 or more, and still more preferably 6 or more, and is more preferably 20 or less, and still more preferably 14 or less.

Examples of the hydrocarbon ring include

monocyclic saturated hydrocarbon rings, such as a cyclopropane ring, a cyclobutane ring, a cyclopentane ring, a cyclohexane ring, a cycloheptane ring, a cyclooctane ring, a cyclononane ring, a cyclodecane ring, a cycloundecane ring, and a cyclododecane ring;
monocyclic non-aromatic unsaturated hydrocarbon rings, such as a cyclopropene ring, a cyclobutene ring, a cyclopropene ring, a cyclohexene ring, a cycloheptene ring, and a cyclooctene ring;
polycyclic non-aromatic hydrocarbon rings, such as a norbornene ring, a norbornadiene ring, a decahydronaphthalene ring, a bicycloundecane ring, and a spirobicyclopentane ring; and
aromatic hydrocarbon rings, such a benzene ring, a naphthalene ring, a phenanthrene ring, an anthracene ring, a fluorene ring, a tetracene ring, a chrysene ring, a pyrene ring, a pentacene ring, a benzopyrene ring, a triphenylene ring, a biphenyl ring, a diphenylmethane ring, a diphenyl ether ring, a diphenyl sulfone ring, and a diphenyl ketone ring.

In some embodiments, the hydrocarbon ring has a substituent but does not necessarily have a substituent. Examples of the substituent include halogen atoms, such as a fluorine atom; alkyl groups, such as a methyl group; alkyl halide groups, such as trifluoromethyl group; and aryl groups, such as a phenyl group.

The heterocyclic group or hydrocarbon group represented by $X^1$ is preferably at least one selected from the group consisting of rings represented by the following formulas.

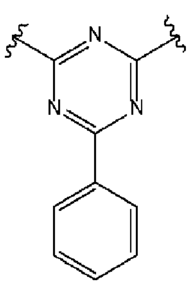
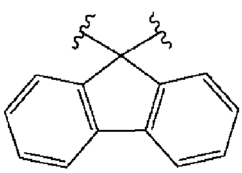
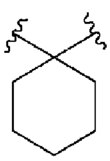
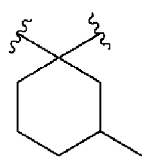
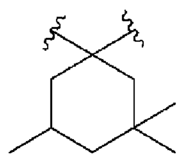
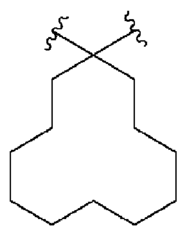
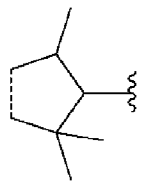

In each formula, each undulating line represents a bond position to the phenylene group represented by Ph, and a broken line represents a carbon-carbon bond shared with the phenylene group represented by Ph.

The fluorine-containing polyether compound having a repeating unit represented by formula (1) preferably has a glass transition temperature of 100 to 400°C, more preferably 110°C or higher, and still more preferably 120°C or higher, and more preferably 300°C or lower, and still more preferably 250°C or lower. The glass transition temperature is a value measured by thermomechanical analysis (TMA), differential scanning calorimetry (DSC), or dynamic viscoelasticity measurement (DMA).

In the fluorine-containing polyether compound having a repeating unit represented by formula (1), the average degree of polymerization of the repeating unit represented by formula (1) is preferably 500 or less, more preferably 400 or less, and still more preferably 300 or less, and is, in some embodiments, 2 or more, or 3 or more. The average degree of polymerization is determined by calculation from the number average molecular weight of the fluorine-containing polyether compound of the present disclosure.

The fluorine-containing polyether compound having a repeating unit represented by formula (1) preferably has a number average molecular weight (Mn) of 2,000 or higher, and more preferably 10,000 or higher, and preferably 500,000 or lower, and more preferably 300,000 or lower, in terms of standard polystyrene, the number average molecular

weight measured by gel permeation chromatography (GPC).

The fluorine-containing polyether compound having a repeating unit represented by formula (1) preferably has a molecular weight distribution (Mw/Mn) of 2 or more, and preferably 5 or less, and more preferably 4 or less, in terms of standard polystyrene, the molecular weight distribution measured by gel permeation chromatography (GPC).

The fluorine-containing polyether compound having a repeating unit represented by formula (1) preferably has a logarithmic viscosity $\eta_{inh}$ of 0.3 dL/g or higher, and more preferably 0.5 dL/g or higher. With regard to the logarithmic viscosity $\eta_{inh}$, the fluorine-containing polyether compound is dissolved in N-methyl-2-pyrrolidone (NMP) or the like as a solvent to prepare a solution whose solution concentration is 0.5 g/L, the solution viscosity of the resultant solution at 30°C is measured, and the logarithmic viscosity $\eta_{inh}$ may be calculated by the following formula.

$$\text{Logarithmic viscosity } \eta_{inh} = \ln(\text{solution viscosity}/\text{solvent viscosity})/\text{solution concentration}$$

The fluorine-containing polyether compound having a repeating unit represented by formula (1) may suitably be produced by polymerizing a dihydroxy compound (11) represented by formula (11) and an active aromatic compound (12) represented by formula (12).

Formula (11): HO-Ph-$X^1$-Ph-OH

wherein Ph and $X^1$ are the same as in formula (1).

Formula (12):

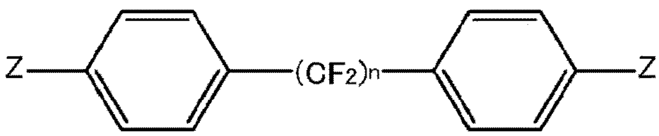

in formula (12), n is the same as in formula (1), and Z represents a halogen atom or a nitro group.

The polymerization of the dihydroxy compound (11) and the active aromatic compound (12) may be performed in the presence of a base. Examples of the base include carbonates, such as sodium carbonate, sodium hydrogen carbonate, potassium carbonate, potassium hydrogen carbonate, cesium carbonate, and cesium hydrogen carbonate; hydroxides, such as sodium hydroxide, potassium hydroxide, and cesium hydroxide; and fluoride compounds, such as sodium fluoride, potassium fluoride, and cesium fluoride.

The polymerization may be performed in a solvent. Examples of the solvent include N,N-dimethylformamide (DMF), N,N-dimethylacetamide (DMAc), N-methyl-2-pyrrolidone (NMP), tetramethylurea (TMU), 1,3-dimethyl-2-imidazolidone (DMI), N,N'-dimethylpropyleneurea (DMPU), dimethyl sulfoxide (DMSO), sulfolane, dimethyl sulfone, diphenyl sulfone, cyclopentanone, cyclohexanone, tetrahydrofuran (THF), and 1,4-dioxane.

To remove water produced by the polymerization of the dihydroxy compound (11) and the active aromatic compound (12) in the presence of a base, an azeotropic solvent, such as toluene, o-xylene, m-xylene, and p-xylene, is used in some embodiments.

The polymerization temperature is preferably 50 to 250°C, and more preferably 150 to 250°C. The polymerization time is preferably 0.1 to 50 hours, and more preferably 1 to 36 hours.

The average degree of polymerization of the repeating unit represented by formula (1) may be adjusted by changing the molar ratio of the dihydroxy compound (11) to the active aromatic compound (12), the polymerization temperature, the polymerization time, the concentration of the polymerization solution, and the others.

Further, the fluorine-containing polyether compound of the present disclosure has a repeating unit represented by formula (2).

Formula (2):

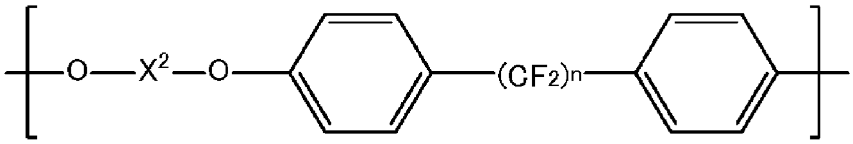

in formula (2), n represents an integer of 1 to 8, and $X^2$ represents a polycyclic aromatic hydrocarbon ring optionally having a substituent.

n represents an integer of 1 to 8. n is preferably an integer of 4 to 8, and more preferably 4, 6, or 8.

$X^2$ represents a polycyclic aromatic hydrocarbon ring. The polycyclic aromatic hydrocarbon ring is a ring formed by removing two hydrogen atoms from a polycyclic aromatic hydrocarbon obtained by condensing two or more aromatic rings, or a ring formed by removing two hydrogen atoms from a polycyclic aromatic hydrocarbon in which two or more aromatic rings are bonded by a single bond. In formula (2), the polycyclic aromatic hydrocarbon ring is directly bonded to two adjacent oxygen atoms.

The carbon number of the polycyclic aromatic hydrocarbon ring is preferably 8 to 30, more preferably 10 or more, and is more preferably 26 or less, and still more preferably 22 or less.

The number of rings of the polycyclic aromatic hydrocarbon ring is preferably 2 to 8, more preferably 6 or less, and still more preferably 5 or less.

Examples of the polycyclic aromatic hydrocarbon ring include a biphenyl ring, a terphenyl ring, a quaterphenyl ring, a naphthalene ring, a phenanthrene ring, an anthracene ring, a fluorene ring, a tetracene ring, a chrysene ring, a pyrene ring, a triphenylene ring, a pentacene ring, a benzopyrene ring, and a perylene ring.

Among these, the polycyclic aromatic hydrocarbon ring is preferably at least one selected from the group consisting of a biphenyl ring, a terphenyl ring, a quaterphenyl ring, a naphthalene ring, an anthracene ring, a tetracene ring, and a pentacene ring.

In some embodiments, the polycyclic aromatic hydrocarbon ring has a substituent but does not necessarily have a substituent. Examples of the substituent include halogen atoms, such as a fluorine atom; alkyl groups, such as a methyl group; alkyl halide groups, such as trifluoromethyl group; and aryl groups, such as a phenyl group.

The fluorine-containing polyether compound having a repeating unit represented by formula (2) preferably has a glass transition temperature of 96 to 400°C, more preferably 100°C or higher, and preferably 300°C or lower, and more preferably 250°C or lower. The glass transition temperature is a value measured by thermomechanical analysis (TMA), differential scanning calorimetry (DSC), or dynamic viscoelasticity measurement (DMA).

In the fluorine-containing polyether compound having a repeating unit represented by formula (2), the average degree of polymerization of the repeating unit represented by formula (2) is preferably 500 or less, more preferably 400 or less, and still more preferably 300 or less, and is, in some embodiments, 2 or more, or 3 or more. The average degree of polymerization is determined by calculation from the number average molecular weight of the fluorine-containing polyether compound of the present disclosure.

The fluorine-containing polyether compound having a repeating unit represented by formula (2) preferably has a number average molecular weight (Mn) of 2,000 or higher, and more preferably 10,000 or higher, and preferably 500,000 or lower, and more preferably 300,000 or lower, in terms of standard polystyrene, the number average molecular weight measured by gel permeation chromatography (GPC).

The fluorine-containing polyether compound having a repeating unit represented by formula (2) preferably has a molecular weight distribution (Mw/Mn) of 2 or more, and preferably 5 or less, and more preferably 4 or less, in terms of standard polystyrene, the molecular weight distribution measured by gel permeation chromatography (GPC).

The fluorine-containing polyether compound having a repeating unit represented by formula (2) preferably has a logarithmic viscosity $\eta_{inh}$ of 0.3 dL/g or higher, and more preferably 0.5 dL/g or higher. With regard to the logarithmic viscosity $\eta_{inh}$, the fluorine-containing polyether compound is dissolved in N-methyl-2-pyrrolidone (NMP) or the like as a solvent to prepare a solution whose solution concentration is 0.5 g/L, the solution viscosity of the resultant solution at 30°C is measured, and the logarithmic viscosity $\eta_{inh}$ may be calculated by the following formula.

$$\text{Logarithmic viscosity } \eta_{inh} = \ln(\text{solution viscosity}/\text{solvent viscosity})/\text{solution concentration}$$

The fluorine-containing polyether compound having a repeating unit represented by formula (2) may suitably be produced by polymerizing a dihydroxy compound (21) represented by formula (21) and an active aromatic compound

(22) represented by formula (22).

Formula (21): HO-$X^2$-OH

in formula (21), $X^2$ is the same as in formula (2).

Formula (22):

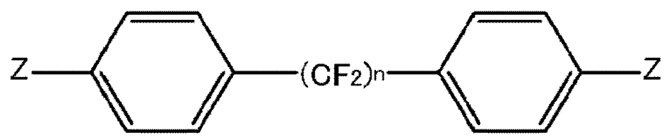

in formula (22), n is the same as in formula (2), and Z represents a halogen atom or a nitro group.

The polymerization of the dihydroxy compound (21) and the active aromatic compound (22) may be performed in the presence of a base. Examples of the base include carbonates, such as sodium carbonate, sodium hydrogen carbonate, potassium carbonate, potassium hydrogen carbonate, cesium carbonate, and cesium hydrogen carbonate; hydroxides, such as sodium hydroxide, potassium hydroxide, and cesium hydroxide; and fluoride compounds, such as sodium fluoride, potassium fluoride, and cesium fluoride.

The polymerization may be performed in a solvent. Examples of the solvent include N,N-dimethylformamide (DMF), N,N-dimethylacetamide (DMAc), N-methyl-2-pyrrolidone (NMP), tetramethylurea (TMU), 1,3-dimethyl-2-imidazolidone (DMI), N,N'-dimethylpropyleneurea (DMPU), dimethyl sulfoxide (DMSO), sulfolane, dimethyl sulfone, diphenyl sulfone, cyclopentanone, cyclohexanone, tetrahydrofuran (THF), and 1,4-dioxane.

To remove water produced by the polymerization of the dihydroxy compound (21) and the active aromatic compound (22) in the presence of a base, an azeotropic solvent, such as toluene, o-xylene, m-xylene, and p-xylene, is used in some embodiments.

The polymerization temperature is preferably 50 to 250°C, and more preferably 150 to 250°C. The polymerization time is preferably 0.1 to 50 hours, and more preferably 1 to 36 hours.

The average degree of polymerization of the repeating unit represented by formula (2) may be adjusted by changing the molar ratio of the dihydroxy compound (21) to the active aromatic compound (22), the polymerization temperature, the polymerization time, the concentration of the polymerization solution, and the others.

The fluorine-containing polyether compound of the present disclosure exhibits sufficiently low dielectric constant and dielectric dissipation factor and has both significantly high glass transition temperature and high solubility, and therefore it may suitably be used as a low dielectric material.

The fluorine-containing polyether compound of the present disclosure exhibits sufficiently low dielectric constant and dielectric dissipation factor and has both significantly high glass transition temperature and high solubility, and therefore it may suitably be used as a substrate for semiconductor package substrates, flexible printed circuit boards, rigid printed circuit boards, or the like.

The fluorine-containing polyether compound of the present disclosure exhibits sufficiently low dielectric constant and dielectric dissipation factor and has both significantly high glass transition temperature and high solubility, and therefore it may suitably be used as a material for semiconductor package wiring boards, flexible printed wiring boards, rigid printed wiring boards, TAB tapes, COF tapes, or metal wiring or the like; cover substrates for metal wiring or chip members such as IC chips; interlayer insulating films for liquid crystal displays, organic electroluminescence displays, electronic paper, solar cells; or electronic components or electronic devices, such as base substrates, adhesive sheets, prepregs, and primers.

The fluorine-containing polyether compound of the present disclosure has a low dielectric constant and a low dielectric loss at high frequencies in particular, and therefore may suitably be used as a material for electronic components or electronic devices using microwaves at high frequencies, microwaves of 3 to 30 GHz in particular. For example, the fluorine-containing polyether compound of the present disclosure may suitably be used as a material for insulating plates for high frequency circuits, insulating materials for connecting components, printed circuit boards, bases or antenna covers for high frequency vacuum tubes, or coated electric wire such as coaxial cables and LAN cables. Further, the fluorine-containing polyether compound of the present disclosure may suitably be used as a material for satellite communication devices or devices in cellular phone base stations, which use microwaves of 3 to 30 GHz.

Examples of the printed circuit board include, but not limited to, printed wiring boards for electronic circuits of cellular phones, various computers, communication devices, and the like.

Examples of the coaxial cable include, but not limited to, coaxial cables having a structure formed by stacking an internal conductor, an insulating coating layer, an external conductor layer, and a protective coating layer in order

from the core to the outer periphery.

The fluorine-containing polyether compound of the present disclosure has a low dielectric constant and a low dielectric loss, has excellent heat resistance, solventsolubility, electrically insulating properties, colorless and transparent characteristics, and flexibility, and is easily made into a thin film, and therefore it may suitably be used for interlayer insulating films, films, adhesive sheets, prepregs, primers, resist materials, and the like. Among these, the fluorine-containing polyether compound of the present disclosure is suitable for interlayer insulating films and films.

The film may be produced by forming the fluorine-containing polyether compound of the present disclosure by a known film forming method, such as an extrusion forming method, a calender forming method, and a solution casting method. Further, in some embodiments, a sand blast treatment, a corona treatment, a plasma treatment, or an etching treatment is performed on the film.

The embodiments have been described above, and it will be understood that various changes in the embodiments and details may be made without departing from the spirit and scope of the claims.

## EXAMPLES

Next, the embodiments of the present disclosure will be described with reference to Examples, but the present disclosure is not limited to those Examples.

Numerical values in Examples were measured by the following methods.

(1) GPC: High Performance GPC system HLC-8220GPC manufactured by Tosoh Corporation (column: Tosoh TSKgel ($\alpha$-M), column temperature: 45°C, detector: UV-8020, wavelength 254 nm, eluent: N-methyl-2-pyrrolidone (NMP) (containing 0.01 mol/L of lithium bromide), calibration curve: standard polystyrene, column flow rate: 0.2 mL/min)
(2) Infrared spectrum (FT-IR): FT/IR-4200 manufactured by JASCO Corporation
(3) Nuclear magnetic resonance spectrum (NMR): AC400P manufactured by BRUKER
(4) Thermogravimetric analysis (TGA): TG/DTA7300 manufactured by Hitachi High-Tech Science Systems Corporation, temperature-increasing rate 10°C/min
(5)Differential scanning calorimetry (DSC): DSC7000 manufactured by Hitachi High-Tech Science Systems Corporation, temperature-increasing rate 20°C/min
(6)Thermomechanical analysis (TMA): TMA7000 manufactured by Hitachi High-Tech Science Systems Corporation, temperature-increasing rate 10°C/min
(7) Dynamic viscoelasticity measurement (DMA): DMA7100 manufactured by Hitachi High-Tech Science Systems Corporation, temperature-increasing rate: 2°C/min
(8)Tensile test: Autograph AGS-D manufactured by SHIMADZU CORPORATION, tensile speed 1.0 mm/min
(9) Ultraviolet-visible spectrophotometer: UV-1800 manufactured by SHIMADZU CORPORATION
(10) Refractive index measurement: Metricon Model 2010/M PRISM COUPLER
(11) Dielectric constant measurement: Dielectric constant and dielectric dissipation factor measurement apparatus manufactured by AET, Inc. (cavity resonator type, 10 GHz, 20 GHz)

<Synthesis Example 1>

Synthesis of 1,6-Bis(4-fluorophenyl)perfluorohexane (FPPFH)

In a round-bottomed flask (100 mL) equipped with a stirring bar, a Dimroth condenser, and a nitrogen introducing tube, 1-fluoro-4-iodobenzene (1.25 mL, 10.8 mmol), dimethyl sulfoxide (DMSO, 15 mL), and 1,6-diiodoperfluorohexane (3.00 g, 5.42 mmol) were placed and dissolved. Thereafter, a copper powder (1.56 g, 24.4 mmol) was added thereto, the temperature of the resultant mixture was increased in stages to 120°C in a nitrogen gas atmosphere, and the mixture was then stirred for 48 hours. After the mixture was left standing to cool to room temperature, the copper powder was removed by suction filtration, and DMSO was distilled away by reduced-pressure distillation. The residue was dissolved in diethyl ether, the resultant solution was subjected to suction filtration, and the filtrate was then washed with distilled water. An organic layer was taken out, and anhydrous sodium sulfate was added thereto to perform dehydration. Thereafter, the resultant was filtered to obtain a filtrate, and diethyl ether was distilled away from the filtrate to give a crude product. The crude yield was 1.73 g, 65%. Purification was performed by reduced-pressure distillation (100°C/0.17 Torr) to give a white crystalline product (yield 1.69 g, 64%).

Melting point: 40 to 41°C
FT-IR (KBr, $cm^{-1}$): 1515 (C=C), 1243 (C-F)
$^1$H-NMR (DMSO-$d_6$, ppm): 7.73 (4H), 7.41 (4H)

$^{13}C$-NMR (DMSO-$d_6$, ppm): 165.5, 163.5, 129.6, 129.5, 123.8, 116.6, 116.4
$^{19}F$-NMR (DMSO-$d_6$, ppm): -107.3, -109.4, -121.5, -122.0
Elemental analysis:

Calculated value C, 44.10%; H, 1.65%
Measured value C, 43.98%; H, 1.72%

<Synthesis Example 2>

Synthesis of 1,4-Bis(4-fluorophenyl)perfluorobutane (FPPFB)

In a round-bottomed flask (100 mL) equipped with a stirring bar, a Dimroth condenser, and a nitrogen introducing tube, 1-fluoro-4-iodobenzene (1.25 mL, 10.8 mmol), dimethyl sulfoxide (DMSO, 15 mL), and 1,4-diiodoperfluorobutane (2.46 g, 5.42 mmol) were placed and dissolved. Thereafter, a copper powder (1.56 g, 24.4 mmol) was added thereto, the temperature of the resultant mixture was increased in stages to 120°C in a nitrogen gas atmosphere, and the mixture was then stirred for 48 hours. After the mixture was left standing to cool to room temperature, the copper powder was removed by suction filtration, and DMSO was distilled away by reduced-pressure distillation. The residue was dissolved in diethyl ether, the resultant solution was subjected to suction filtration, and the filtrate was then washed with distilled water. An organic layer was taken out, and anhydrous sodium sulfate was added thereto to perform dehydration. Thereafter, the resultant was filtered to obtain a filtrate, and diethyl ether was distilled away from the filtrate to give a crude product. The crude yield was 0.95 g, 45%. Purification was performed by reduced-pressure distillation (100°C/0.17 Torr) to give a white crystalline product (yield 0.93 g, 44%).

Melting point: 63 to 64°C
$^{1}H$-NMR (DMSO-$d_6$, ppm): 7.69 (4H), 7.43 (4H)
$^{13}C$-NMR (DMSO-$d_6$, ppm): 165.4, 163.4, 129.5, 124.4, 116.5, 116.3 $^{19}F$-NMR (DMSO-$d_6$, ppm): -107.7, -109.3, -121.4
Elemental analysis:

Calculated value C, 49.24%; H, 2.07%
Measured value C, 48.89%; H, 1.93%

<Synthesis Example 3>

Synthesis of 1,6-Bis(4-chlorophenyl)perfluorohexane (CPPFH)

In a round-bottomed flask (100 mL) equipped with a stirring bar, a Dimroth condenser, and a nitrogen introducing tube, 1-chloro-4-iodobenzene (4.77 g, 20 mmol), dimethyl sulfoxide (DMSO, 15 mL), and 1,6-diiodoperfluorohexane (5.54 g, 10 mmol) were placed and dissolved. Thereafter, a copper powder (3.18 g, 50 mmol) was added thereto, the temperature of the resultant mixture was increased in stages to 120°C in a nitrogen gas atmosphere, and the mixture was then stirred for 12 hours. After the mixture was left standing to cool to room temperature, the copper powder was removed by suction filtration, and DMSO was distilled away by reduced-pressure distillation. The residue was dissolved in t-butyl methyl ether, the resultant solution was subjected to suction filtration, and the filtrate was then washed with distilled water. An organic layer was taken out, and anhydrous sodium sulfate was added thereto to perform dehydration. Thereafter, the resultant was filtered to obtain a filtrate, and t-butyl methyl ether was distilled away from the filtrate to give a crude product. The crude product was purified by sublimation (80°C/0.2 Torr) to give a white powdery crystalline product (yield 4.55 g, 87%).

Melting point: 87 to 88°C
$^{1}H$-NMR ($CDCl_3$, ppm): 7.53 (4H), 7.47 (4H)
$^{13}C$-NMR ($CDCl_3$, ppm): 138.6, 129.1, 128.5, 128.4
$^{19}F$-NMR ($CDCl_3$, ppm): -111.8, -122.4, -123.0
FT-IR (KBr, $cm^{-1}$): 1604 (C=C), 1216-1132 (C-F), 1092 (C-Cl)
Elemental analysis ($C_{18}H_8F_{12}Cl_2$):

Calculated value C, 41.32%; H, 1.54%
Measured value C, 41.41%; H, 1.68%

<Synthesis Example 4>

Synthesis of 1,6-Bis(4-nitrophenyl)perfluorohexane (NPPFH)

In a round-bottomed flask (100 mL) equipped with a stirring bar, a Dimroth condenser, and a nitrogen introducing tube, 1-iodo-4-nitrobenzene (4.98 g, 20 mmol), dimethyl sulfoxide (DMSO, 15 mL), and 1,6-diiodoperfluorohexane (5.54 g, 10 mmol) were placed and dissolved. Thereafter, a copper powder (3.18 g, 50 mmol) was added thereto, the temperature of the resultant mixture was increased in stages to 120°C in a nitrogen gas atmosphere, and the mixture was then stirred for 12 hours. After the mixture was left standing to cool to room temperature, the copper powder was removed by suction filtration, and DMSO was distilled away by reduced-pressure distillation. The residue was dissolved in t-butyl methyl ether, the resultant solution was subjected to suction filtration, and the filtrate was then washed with distilled water. An organic layer was taken out, and anhydrous sodium sulfate was added thereto to perform dehydration. Thereafter, the resultant was filtered to obtain a filtrate, and t-butyl methyl ether was distilled away from the filtrate to give a crude product. After the crude product was purified by sublimation (160°C/0.17 Torr), recrystallization was performed with a mixed solvent of THF/hexane. The recrystallized product was dried under reduced pressure at 100°C for 12 hours to give a light-yellow needle crystalline product (yield 2.78 g, 51%).

Melting point: 168 to 169°C
$^1$H-NMR ($CDCl_3$, ppm): 8.39 (4H), 7.82 (4H)
$^{13}$C-NMR ($CDCl_3$, ppm): 150.3, 135.1, 128.6, 124.0
$^{19}$F-NMR ($CDCl_3$, ppm): -112.0, -122.0, -122.4
FT-IR (KBr, $cm^{-1}$): 1550 ($NO_2$), 1291 ($NO_2$), 1215-1132 (C-F)
Elemental analysis ($C_{18}H_8N_2O_4F_{12}$):

Calculated value C, 39.72%; H, 1.48%; N, 5.15%
Measured value C, 39.46%; H, 1.55%; N, 5.12%

<Example 1>

Synthesis of Fluorine-Containing Polyether (FPPFH-BisZ)

In a two-necked flask (50 mL) equipped with a stirring bar, a nitrogen introducing tube, a Dean-Stark trap, and a Dimroth condenser, FPPFH (0.981 g, 2.0 mmol) and 4,4'-(cyclohexylidene)bisphenol (BisZ, 0.537 g, 2.0 mmol) were placed and dissolved in distilled 1,3-dimethyl-2-imidazolidone (DMI, 5.0 mL). Thereafter, potassium carbonate (0.332 g, 2.4 mmol) and toluene (20 mL) were added thereto. The temperature of the resultant mixture was increased in stages to 150°C, and the mixture was then stirred at 150°C for 2 hours to remove water by azeotropy. Thereafter, the mixture was stirred at 170°C for 12 hours. After the mixture was left standing to cool to room temperature, a polymer was collected with methanol. The polymer was cleaned with methanol while heating, and then dried under reduced pressure at room temperature. The polymer was dissolved in chloroform, and the resultant solution was poured into a large amount of methanol to purify the polymer by reprecipitation. The polymer was dried under reduced pressure at room temperature for 10 hours.

Yield of polymer: 1.09 g (72%)
Logarithmic viscosity ($\eta_{inh}$): 1.26 dL/g (0.5 g/dL concentration solution in NMP, measured at 30°C)
Number average molecular weight (Mn): 200,000, Molecular weight distribution (Mw/Mn): 2.4

This polymer was dissolved in chloroform, and the resultant solution was cast onto a glass plate and dried at room temperature for 6 hours, subsequently at 50°C for 3 hours, and then under reduced pressure at 100°C for 3 hours to prepare a colorless transparent cast film (film thickness 35 $\mu$m).

FT-IR (film, $cm^{-1}$): 2937 (C-H), 2862 (C-H), 1600 (C=C), 1504 (C=C), 1292-1143 (C-F)
Solubility: soluble to NMP, DMAc, TMU, DMI, THF, chloroform, ethyl acetate, cyclohexanone, and cyclopentanone at room temperature
5% Weight loss temperature: 387°C (in air), 492°C (in nitrogen)
10% Weight loss temperature: 404°C (in air), 504°C (in nitrogen)
Carbonization yield: 42% (in nitrogen, 800°C)
Glass transition temperature (Tg): 112°C (DSC), 113°C (TMA), 109°C (DMA)
Coefficient of thermal expansion (CTE): 88 ppm/°C (50°C to 80°C)

Tensile strength at break: 45 MPa
Elongation at break: 5.2%
Tensile elasticity: 1.4 GPa
Cut-off wavelength: 290 nm
Transmission at 500 nm: 83%,
Average refractive index ($n_{ave}$): 1.538 (d line)
Birefringence ($\Delta n$): 0.001 (d line)
Dielectric constant ($\varepsilon$) calculated from refractive index: 2.37 ($\varepsilon = n_{ave}^2$)
Dielectric constant (Dk): 2.44 (TE mode, 10 GHz), 2.38 (TE mode, 20 GHz)
Dielectric dissipation factor (Df): 0.0021 (TE mode, 10 GHz), 0.0022 (TE mode, 20 GHz)

<Example 2>

Synthesis of Fluorine-Containing Polyether (FPPFH-BisP3MZ)

In a two-necked flask (50 mL) equipped with a stirring bar, a nitrogen introducing tube, a Dean-Stark trap, and a Dimroth condenser, FPPFH (0.981 g, 2.0 mmol) and 4,4'-(3-methylcyclohexylidene)bisphenol (BisP3MZ, 0.565 g, 2.0 mmol) were placed and dissolved in distilled 1,3-dimethyl-2-imidazolidone (DMI, 5.0 mL). Thereafter, potassium carbonate (0.332 g, 2.4 mmol) and toluene (20 mL) were added thereto. The temperature of the resultant mixture was increased in stages to 150°C, and the mixture was then stirred at 150°C for 2 hours to remove water by azeotropy. Thereafter, the mixture was stirred at 170°C for 24 hours. After the mixture was left standing to cool to room temperature, a polymer was collected with methanol. The polymer was cleaned with methanol while heating, and then dried under reduced pressure at room temperature. The polymer was dissolved in chloroform, and the resultant solution was poured into a large amount of methanol to purify the polymer by reprecipitation. The polymer was dried under reduced pressure at room temperature for 10 hours.

Yield of polymer: 1.19 g (77%)
Logarithmic viscosity ($\eta_{inh}$): 0.76 dL/g (0.5 g/dL concentration solution in NMP, measured at 30°C)
Number average molecular weight (Mn): 98,000, Molecular weight distribution (Mw/Mn): 2.7

This polymer was dissolved in chloroform, and the resultant solution was cast onto a glass plate and dried at room temperature for 6 hours, subsequently at 50°C for 3 hours, and then under reduced pressure at 120°C for 3 hours to prepare a colorless transparent cast film (film thickness 50 $\mu$m).

FT-IR (film, $cm^{-1}$): 2937 (C-H), 2862 (C-H), 1600 (C=C), 1504 (C=C), 1292-1143 (C-F)
$^{1}$H-NMR ($CDCl_3$, ppm): 7.51 (d, 4H), 7.37 (d, 2H), 7.18 (d, 2H), 7.02 (q, 6H), 6.91 (d, 2H), 2.62 (q, 2H), 1.82 (t, 1H), 1.71 (d, 2H), 1.52 (q, 3H), 0.96 (d, 4H)
$^{13}$C-NMR ($CDCl_3$, ppm): 160.9, 153.4, 148.0, 141.9, 129.7, 128.8, 127.9, 123.1, 119.9, 117.8, 46.3, 37.0, 35.2, 28.8, 23.1 $^{19}$F-NMR ($CDCl_3$, ppm): -111.1, -122.6, -123.2

Solubility: soluble to NMP, DMAc, TMU, DMI, THF, chloroform, ethyl acetate, cyclohexanone, and cyclopentanone at room temperature
5% Weight loss temperature: 379°C (in air), 479°C (in nitrogen)
10% Weight loss temperature: 393°C (in air), 490°C (in nitrogen)
Carbonization yield: 46% (in nitrogen, 800°C)
Glass transition temperature (Tg): 132°C (DSC), 132°C (TMA), 128°C (DMA)
Coefficient of thermal expansion (CTE): 88 ppm/°C (50°C to 80°C)
Tensile strength at break: 53 MPa
Elongation at break: 4.3%
Tensile elasticity: 1.4 GPa
Cut-off wavelength: 292 nm
Transmission at 500 nm: 80%,
Average refractive index ($n_{ave}$): 1.531 (d line)
Birefringence ($\Delta n$): 0.004 (d line)
Dielectric constant ($\varepsilon$) calculated from refractive index: 2.34 ($\varepsilon = n_{ave}^2$)
Dielectric constant (Dk): 2.43 (TE mode, 10 GHz), 2.37 (TE mode, 20 GHz)
Dielectric dissipation factor (Df): 0.0015 (TE mode, 10 GHz), 0.0016 (TE mode, 20 GHz)

<Example 3>

Synthesis of Fluorine-Containing Polyether (FPPFH-BisPHTG)

In a two-necked flask (50 mL) equipped with a stirring bar, a nitrogen introducing tube, a Dean-Stark trap, and a Dimroth condenser, FPPFH (0.981 g, 2.0 mmol) and 4,4'-(3,3,5-trimethylcyclohexylidene)bisphenol (BisPHTG, 0.621 g, 2.0 mmol) were placed and dissolved in distilled 1,3-dimethyl-2-imidazolidone (DMI, 5.0 mL). Thereafter, potassium carbonate (0.332 g, 2.4 mmol) and toluene (20 mL) were added thereto. The temperature of the resultant mixture was increased in stages to 150°C, and the mixture was then stirred at 150°C for 2 hours to remove water by azeotropy. Thereafter, the mixture was stirred at 170°C for 24 hours. After the mixture was left standing to cool to room temperature, a polymer was collected with methanol. The polymer was cleaned with methanol while heating, and then dried under reduced pressure at room temperature. The polymer was dissolved in chloroform, and the resultant solution was poured into a large amount of methanol to purify the polymer by reprecipitation. The polymer was dried under reduced pressure at room temperature for 10 hours.

Yield of polymer: 1.33 g (83%)
Logarithmic viscosity ($\eta_{inh}$): 0.45 dL/g (0.5 g/dL concentration solution in NMP, measured at 30°C)
Number average molecular weight (Mn): 43,000, Molecular weight distribution (Mw/Mn): 2.2

This polymer was dissolved in chloroform, and the resultant solution was cast onto a glass plate and dried at room temperature for 6 hours, subsequently at 50°C for 3 hours, and then under reduced pressure at 120°C for 3 hours to prepare a colorless transparent cast film (film thickness 51 $\mu$m).

FT-IR (film, $cm^{-1}$): 2937 (C-H), 2862 (C-H), 1600 (C=C), 1504 (C=C), 1292-1143 (C-F)
$^1$H-NMR ($CDCl_3$, ppm): 7.49 (t, 4H), 7.38 (d, 2H), 7.25 (t, 2H), 6.99 (q, 6H), 6.92 (d, 2H), 2.72 (d, 1H), 2.49 (d, 1H), 2.04 (s, 1H), 1.96 (d, 1H), 1.44 (d, 1H), 1.21 (t, 1H), 1.01 (d, 6H), 0.90 (t, 1H), 0.41 (s, 3H)
$^{13}$C-NMR ($CDCl_3$, ppm): 160.9, 153.1, 148.8, 143.3, 129.3, 128.8, 127.6, 123.1, 119.8, 117.6, 48.8, 48.4, 46.3, 45.4, 35.0, 32.4, 26.9, 25.7, 22.8
$^{19}$F-NMR ($CDCl_3$, ppm): -111.1, -122.6, -123.2

Solubility: soluble to NMP, DMAc, TMU, DMI, THF, chloroform, ethyl acetate, cyclohexanone, cyclopentanone, and acetone at room temperature
5% Weight loss temperature: 458°C (in air), 493°C (in nitrogen)
10% Weight loss temperature: 482°C (in air), 503°C (in nitrogen)
Carbonization yield: 38% (in nitrogen, 800°C)
Glass transition temperature (Tg): 140°C (DSC), 136°C (TMA), 130°C (DMA)
Coefficient of thermal expansion (CTE): 96 ppm/°C (50°C to 80°C)
Tensile strength at break: 53 MPa
Elongation at break: 4.8%
Tensile elasticity: 1.5 GPa
Cut-off wavelength: 293 nm
Transmission at 500 nm: 85%,
Average refractive index ($n_{ave}$): 1.523 (d line)
Birefringence ($\Delta$n): 0.002 (d line)
Dielectric constant ($\varepsilon$) calculated from refractive index: 2.32 ($\varepsilon = n_{ave}^2$)
Dielectric constant (Dk): 2.42 (TE mode, 10 GHz), 2.36 (TE mode, 20 GHz)
Dielectric dissipation factor (Df): 0.0033 (TE mode, 10 GHz), 0.0036 (TE mode, 20 GHz)

<Example 4>

Synthesis of Fluorine-Containing Polyether (FPPFH-BisPCDE)

In a two-necked flask (50 mL) equipped with a stirring bar, a nitrogen introducing tube, a Dean-Stark trap, and a Dimroth condenser, FPPFH (0.981 g, 2.0 mmol) and 4,4'-cyclododecylidenebisphenol (BisPCDE, 0.705 g, 2.0 mmol) were placed and dissolved in distilled 1,3-dimethyl-2-imidazolidone (DMI, 5.0 mL). Thereafter, potassium carbonate (0.332 g, 2.4 mmol) and toluene (20 mL) were added thereto. The temperature of the resultant mixture was increased in stages to 150°C, and the mixture was then stirred at 150°C for 2 hours to remove water by azeotropy. Thereafter, the mixture was stirred at 170°C for 24 hours. After the mixture was left standing to cool to room temperature, a polymer

was collected with methanol. The polymer was cleaned with methanol while heating, and then dried under reduced pressure at room temperature. The polymer was dissolved in chloroform, and the resultant solution was poured into a large amount of methanol to purify the polymer by reprecipitation. The polymer was dried under reduced pressure at room temperature for 10 hours.

Yield of polymer: 1.28 g (76%)
Logarithmic viscosity ($\eta_{inh}$): 0.64 dL/g (0.5 g/dL concentration solution in NMP, measured at 30°C)
Number average molecular weight (Mn): 68,000, Molecular weight distribution (Mw/Mn): 2.3

This polymer was dissolved in chloroform, and the resultant solution was cast on a glass plate and dried at room temperature for 6 hours, subsequently at 50°C for 3 hours, and then under reduced pressure at 140°C for 5 hours to prepare a colorless transparent cast film (film thickness 56 μm).

FT-IR (film, $cm^{-1}$): 2937 (C-H), 2862 (C-H), 1600 (C=C), 1504 (C=C), 1292-1143 (C-F)
Solubility: soluble to NMP, DMAc, TMU, DMI, THF, chloroform, ethyl acetate, cyclohexanone, and cyclopentanone at room temperature
5% Weight loss temperature: 343°C (in air), 423°C (in nitrogen)
10% Weight loss temperature: 364°C (in air), 441°C (in nitrogen)
Carbonization yield: 36% (in nitrogen, 800°C)
Glass transition temperature (Tg): 155°C (DSC), 156°C (TMA), 151°C (DMA)
Coefficient of thermal expansion (CTE): 85 ppm/°C (50°C to 80°C)
Tensile strength at break: 64 MPa
Elongation at break: 6.1%
Tensile elasticity: 1.7 GPa
Cut-off wavelength: 292 nm
Transmission at 500 nm: 78%,
Average refractive index ($n_{ave}$): 1.527 (d line)
Birefringence ($\Delta n$): 0.002 (d line)
Dielectric constant ($\varepsilon$) calculated from refractive index: 2.33 ($\varepsilon = n_{ave}^2$)
Dielectric constant (Dk): 2.42 (TE mode, 10 GHz), 2.37 (TE mode, 20 GHz)
Dielectric dissipation factor (Df): 0.0011 (TE mode, 10 GHz), 0.0012 (TE mode, 20 GHz)

<Example 5>

Synthesis of Fluorine-Containing Polyether (FPPFH-BisPIND)

In a two-necked flask (50 mL) equipped with a stirring bar, a nitrogen introducing tube, a Dean-Stark trap, and a Dimroth condenser, FPPFH (0.981 g, 2.0 mmol) and 3-(4-hydroxyphenyl)-1,1,3-trimethyl-5-indanol (BisPIND, 0.537 g, 2.0 mmol) were placed and dissolved in distilled 1,3-dimethyl-2-imidazolidone (DMI, 5.0 mL). Thereafter, potassium carbonate (0.332 g, 2.4 mmol) and toluene (20 mL) were added thereto. The temperature of the resultant mixture was increased in stages to 150°C, and the mixture was then stirred at 150°C for 2 hours to remove water by azeotropy. Thereafter, the mixture was stirred at 170°C for 24 hours. After the mixture was left standing to cool to room temperature, a polymer was collected with methanol. The polymer was cleaned with methanol while heating, and then dried under reduced pressure at room temperature. The polymer was dissolved in chloroform, and the resultant solution was poured into a large amount of methanol to purify the polymer by reprecipitation. The polymer was dried under reduced pressure at room temperature for 10 hours.

Yield of polymer: 0.97 g (64%)
Logarithmic viscosity ($\eta_{inh}$): 0.91 dL/g (0.5 g/dL concentration solution in NMP, measured at 30°C)
Number average molecular weight (Mn): 116,000, Molecular weight distribution (Mw/Mn): 2.7

This polymer was dissolved in chloroform, and the resultant solution was cast onto a glass plate and dried at room temperature for 6 hours, subsequently at 50°C for 3 hours, and then under reduced pressure at 110°C for 3 hours to prepare a colorless transparent cast film (film thickness 58 μm).

FT-IR (film, $cm^{-1}$): 2937 (C-H), 2862 (C-H), 1600 (C=C), 1504 (C=C), 1292-1143 (C-F)
$^1$H-NMR ($CDCl_3$, ppm): 7.49 (d, 4H), 7.19 (t, 3H), 7.04-6.92 (q, 7H), 6.84 (d, 1H), 2.45 (d, 1H), 2.27 (d, 1H), 1.68 (s, 3H), 1.37 (s, 3H), 1.09 (s, 3H)

$^{13}C$-NMR ($CDCl_3$, ppm): 161.4, 161.0, 154.5, 153.4, 151.1, 148.7, 146.9, 128.8, 128.3, 124.2, 119.7, 117.6, 116.8, 59.6, 50.5, 42.7, 30.9
$^{19}F$-NMR ($CDCl_3$, ppm): -111.1, -122.6, -123.1

Solubility: soluble to DMF, DMAc, NMP, TMU, DMI, THF, chloroform, ethyl acetate, cyclohexanone, cyclopentanone, and acetone at room temperature
5% Weight loss temperature: 425°C (in air), 493°C (in nitrogen)
10% Weight loss temperature: 440°C (in air), 501°C (in nitrogen)
Carbonization yield: 51% (in nitrogen, 800°C)
Glass transition temperature (Tg): 123°C (DSC), 125°C (TMA), 121°C (DMA)
Coefficient of thermal expansion (CTE): 90 ppm/°C (50°C to 80°C)
Tensile strength at break: 43 MPa
Elongation at break: 3.6%
Tensile elasticity: 1.1 GPa
Cut-off wavelength: 293 nm
Transmission at 500 nm: 84%,
Average refractive index ($n_{ave}$): 1.527 (d line)
Birefringence ($\Delta n$): 0.001 (d line)
Dielectric constant ($\varepsilon$) calculated from refractive index: 2.33 ($\varepsilon = n_{ave}^2$)
Dielectric constant (Dk): 2.43 (TE mode, 10 GHz), 2.36 (TE mode, 20 GHz)
Dielectric dissipation factor (Df): 0.0031 (TE mode, 10 GHz), 0.0033 (TE mode, 20 GHz)

<Example 6>

Synthesis of Fluorine-Containing Polyether (FPPFH-BPFL)

In a two-necked flask (50 mL) equipped with a stirring bar, a nitrogen introducing tube, a Dean-Stark trap, and a Dimroth condenser, FPPFH (0.981 g, 2.0 mmol) and 9,9-bis(4-hydroxyphenyl)fluorene (BPFL, 0.701 g, 2.0 mmol) were placed and dissolved in distilled 1,3-dimethyl-2-imidazolidone (DMI, 5.0 mL). Thereafter, potassium carbonate (0.332 g, 2.4 mmol) and toluene (20 mL) were added thereto. The temperature of the resultant mixture was increased in stages to 150°C, and the mixture was then stirred at 150°C for 2 hours to remove water by azeotropy. Thereafter, the mixture was stirred at 170°C for 24 hours. After the mixture was left standing to cool to room temperature, a polymer was collected with methanol. The polymer was cleaned with methanol while heating, and then dried under reduced pressure at room temperature. The polymer was dissolved in chloroform, and the resultant solution was poured into a large amount of methanol to purify the polymer by reprecipitation. The polymer was dried under reduced pressure at room temperature for 10 hours.

Yield of polymer: 1.28 g (76%)
Logarithmic viscosity ($\eta_{inh}$): 1.15 dL/g (0.5 g/dL concentration solution in NMP, measured at 30°C)
Number average molecular weight (Mn): 144,000, Molecular weight distribution (Mw/Mn): 2.3

This polymer was dissolved in chloroform, and the resultant solution was cast onto a glass plate and dried at room temperature for 6 hours, subsequently at 50°C for 3 hours, and then under reduced pressure at 160°C for 3 hours to prepare a colorless transparent cast film (film thickness 53 $\mu$m).

FT-IR (film, $cm^{-1}$): 2937 (C-H), 2862 (C-H), 1600 (C=C), 1504 (C=C), 1292-1143 (C-F)
$^{1}H$-NMR ($CDCl_3$, ppm): 7.78 (d, 2H), 7.49 (d, 4H), 7.41 (d, 4H), 7.32 (t, 2H), 7.23 (d, 4H), 7.02 (d, 4H), 6.90 (d, 4H)
$^{13}C$-NMR ($CDCl_3$, ppm): 160.6, 154.6, 151.1, 142.0, 140.2, 129.8, 128.8, 127.9, 126.2, 123.4, 120.5, 119.7, 117.9, 64.6
$^{19}F$-NMR ($CDCl_3$, ppm): -111.2, -122.7, -123.2
Elemental analysis:

Calculated value C,64.50%; H, 3.02%
Measured value C, 64.17%; H, 3.14%

Solubility: soluble to DMF, DMAc, NMP, TMU, DMI, THF, chloroform, ethyl acetate, cyclohexanone, and cyclopentanone at room temperature
5% Weight loss temperature: 530°C (in air), 546°C (in nitrogen)

10% Weight loss temperature: 550°C (in air), 562°C (in nitrogen)
Carbonization yield: 57% (in nitrogen, 800°C)
Glass transition temperature (Tg): 172°C (DSC), 172°C (TMA), 171°C (DMA)
Coefficient of thermal expansion (CTE): 71 ppm/°C (50°C to 80°C)
Tensile strength at break: 54 MPa
Elongation at break: 4.8%
Tensile elasticity: 1.6 GPa
Cut-off wavelength: 316 nm
Transmission at 500 nm: 80%,
Average refractive index ($n_{ave}$): 1.572 (d line)
Birefringence ($\Delta n$): 0.002 (d line)
Dielectric constant ($\varepsilon$) calculated from refractive index: 2.47 ($\varepsilon = n_{ave}^2$)
Dielectric constant (Dk): 2.46 (TE mode, 10 GHz), 2.41 (TE mode, 20 GHz)
Dielectric dissipation factor (Df): 0.0019 (TE mode, 10 GHz), 0.0020 (TE mode, 20 GHz)

<Example 7>

Synthesis of Fluorine-Containing Polyether (FPPFH-BMPFL)

In a two-necked flask (50 mL) equipped with a stirring bar, a nitrogen introducing tube, a Dean-Stark trap, and a Dimroth condenser, FPPFH (0.981 g, 2.0 mmol) and 9,9-bis(4-hydroxy-3-methylphenyl)fluorene (BMPFL, 0.757 g, 2.0 mmol) were placed and dissolved in distilled 1,3-dimethyl-2-imidazolidone (DMI, 5.0 mL). Thereafter, potassium carbonate (0.332 g, 2.4 mmol) and toluene (20 mL) were added thereto. The temperature of the resultant mixture was increased in stages to 150°C, and the mixture was then stirred at 150°C for 2 hours to remove water by azeotropy. Thereafter, the mixture was stirred at 170°C for 24 hours. After the mixture was left standing to cool to room temperature, a polymer was collected with methanol. The polymer was cleaned with methanol while heating, and then dried under reduced pressure at room temperature. The polymer was dissolved in chloroform, and the resultant solution was poured into a large amount of methanol to purify the polymer by reprecipitation. The polymer was dried under reduced pressure at room temperature for 10 hours.

Yield of polymer: 1.41 g (81%)
Logarithmic viscosity ($\eta_{inh}$): 0.42 dL/g (0.5 g/dL concentration solution in NMP, measured at 30°C)
Number average molecular weight (Mn): 45,000, Molecular weight distribution (Mw/Mn): 2.4

This polymer was dissolved in chloroform, and the resultant solution was cast onto a glass plate and dried at room temperature for 6 hours, subsequently at 50°C for 3 hours, and then under reduced pressure at 160°C for 3 hours to prepare a colorless transparent cast film (film thickness 53 $\mu$m).

$^1$H-NMR ($CDCl_3$, ppm): 7.81 (d, 2H), 7.47 (m, 6H), 7.40 (t, 2H), 7.32 (t, 2H), 7.11 (d, 4H), 6.94 (d, 4H), 6.85 (d, 2H), 2.08 (s, 6H)
$^{19}$F-NMR ($CDCl_3$, ppm): -110.9, -122.5, -123.0

Solubility: soluble to DMF, DMAc, NMP, TMU, DMI, THF, chloroform, ethyl acetate, cyclohexanone, and cyclopentanone at room temperature
5% Weight loss temperature: 426°C (in air), 439°C (in nitrogen)
10% Weight loss temperature: 452°C (in air), 461°C (in nitrogen)
Carbonization yield: 64% (in nitrogen, 800°C)
Glass transition temperature (Tg): 168°C (DSC), 169°C (TMA), 166°C (DMA)
Coefficient of thermal expansion (CTE): 81 ppm/°C (50°C to 80°C)
Tensile strength at break: 61 MPa
Elongation at break: 5.1%
Tensile elasticity: 2.1 GPa
Cut-off wavelength: 3116 nm
Transmission at 500 nm: 79%,
Average refractive index ($n_{ave}$): 1.568 (d line)
Birefringence ($\Delta n$): 0.002 (d line)
Dielectric constant ($\varepsilon$) calculated from refractive index: 2.46 ($\varepsilon = n_{ave}^2$)
Dielectric constant (Dk): 2.45 (TE mode, 10 GHz), 2.40 (TE mode, 20 GHz)

Dielectric dissipation factor (Df): 0.0020 (TE mode, 10 GHz), 0.0019 (TE mode, 20 GHz)

<Example 8>

Synthesis of Fluorine-Containing Polyether (FPPFH-BP)

In a two-necked flask (50 mL) equipped with a stirring bar, a nitrogen introducing tube, a Dean-Stark trap, and a Dimroth condenser, FPPFH (0.981 g, 2.0 mmol) and 4,4-dihydroxybiphenyl (BP, 0.372 g, 2.0 mmol) were placed and dissolved in distilled 1,3-dimethyl-2-imidazolidone (DMI, 5.0 mL). Thereafter, potassium carbonate (0.332 g, 2.4 mmol) and toluene (20 mL) were added thereto. The temperature of the resultant mixture was increased in stages to 150°C, and the mixture was then stirred at 150°C for 2 hours to remove water by azeotropy. Thereafter, the mixture was stirred at 170°C for 12 hours. After the mixture was left standing to cool to room temperature, a polymer was collected with methanol. The polymer was cleaned with methanol while heating, and then dried under reduced pressure at room temperature. The polymer was dissolved in tetrahydrofuran (THF), and the resultant solution was poured into a large amount of methanol to purify the polymer by reprecipitation. The polymer was dried under reduced pressure at room temperature for 10 hours.

Yield of polymer: 0.93 g (69%)
Logarithmic viscosity ($\eta_{inh}$): 0.85 dL/g (0.5 g/dL concentration solution in NMP, measured at 30°C)

This polymer was dissolved in THF, and the resultant solution was cast onto a glass plate and dried at room temperature for 6 hours, subsequently at 50°C for 3 hours, and then under reduced pressure at 90°C for 3 hours to prepare a colorless transparent cast film (film thickness 42 $\mu$m).

FT-IR (film, $cm^{-1}$): 1600 (C=C), 1504 (C=C), 1292-1143 (C-F)
Solubility: soluble to DMAc, NMP, TMU, DMI, THF, and cyclopentanone at room temperature
5% Weight loss temperature: 507°C (in air), 542°C (in nitrogen)
10% Weight loss temperature: 531°C (in air), 555°C (in nitrogen)
Carbonization yield: 44% (in nitrogen, 800°C)
Glass transition temperature (Tg): 103°C (DSC), 105°C (TMA), 114°C (DMA)
Coefficient of thermal expansion (CTE): 94 ppm/°C (50°C to 80°C)
Tensile strength at break: 27 MPa
Elongation at break: 16.7%
Tensile elasticity: 1.1 GPa
Cut-off wavelength: 308 nm
Transmission at 500 nm: 86%,
Average refractive index ($n_{ave}$): 1.551 (d line)
Birefringence ($\Delta n$): 0.011 (d line)
Dielectric constant ($\varepsilon$) calculated from refractive index: 2.41 ($\varepsilon = n_{ave}^2$)
Dielectric constant (Dk): 2.44 (TE mode, 10 GHz), 2.40 (TE mode, 20 GHz)
Dielectric dissipation factor (Df): 0.0021 (TE mode, 10 GHz), 0.0023 (TE mode, 20 GHz)

<Example 9>

Synthesis of Fluorine-Containing Polyether (FPPFH-NDO)

In a two-necked flask (50 mL) equipped with a stirring bar, a nitrogen introducing tube, a Dean-Stark trap, and a Dimroth condenser, FPPFH (0.981 g, 2.0 mmol) and 2,6-dihydroxynaphthalene (NDO, 0.320 g, 2.0 mmol) were placed and dissolved in distilled 1,3-dimethyl-2-imidazolidone (DMI, 5.0 mL). Thereafter, potassium carbonate (0.332 g, 2.4 mmol) and toluene (20 mL) were added thereto. The temperature of the resultant mixture was increased in stages to 150°C, and the mixture was then stirred at 150°C for 2 hours to remove water by azeotropy. Thereafter, the mixture was stirred at 170°C for 24 hours. After the mixture was left standing to cool to room temperature, a polymer was collected with methanol. The polymer was cleaned with methanol while heating, and then dried under reduced pressure at room temperature. The polymer was dissolved in tetrahydrofuran (THF), and the resultant solution was poured into a large amount of methanol to purify the polymer by reprecipitation. The polymer was dried under reduced pressure at room temperature for 10 hours.
Logarithmic viscosity ($\eta_{inh}$): 0.41 dL/g (0.5 g/dL concentration solution in NMP, measured at 30°C)
This polymer was dissolved in THF, and the resultant solution was cast onto a glass plate and dried at room temperature

for 6 hours, subsequently at 50°C for 3 hours, and then under reduced pressure at 90°C for 3 hours to prepare a light-yellow transparent cast film.

Solubility: soluble to DMF, DMAc, NMP, TMU, DMI, THF, and cyclopentanone at room temperature
5% Weight loss temperature: 438°C (in air), 535°C (in nitrogen)
10% Weight loss temperature: 484°C (in air), 556°C (in nitrogen)
Carbonization yield: 49% (in nitrogen, 800°C)
Glass transition temperature (Tg): 97°C (DSC), 98°C (TMA), 98°C (DMA)
Coefficient of thermal expansion (CTE): 99 ppm/°C (50°C to 80°C)
Tensile strength at break: 28 MPa
Elongation at break: 3.9%
Tensile elasticity: 1.3 GPa
Cut-off wavelength: 348 nm
Transmission at 500 nm: 55%,
Average refractive index ($n_{ave}$): 1.554 (d line)
Birefringence ($\Delta n$): 0.002 (d line)
Dielectric constant ($\varepsilon$) calculated from refractive index: 2.41 ($\varepsilon = n_{ave}^2$)
Dielectric constant (Dk): 2.45 (TE mode, 10 GHz), 2.42 (TE mode, 20 GHz)
Dielectric dissipation factor (Df): 0.0032 (TE mode, 10 GHz), 0.0032 (TE mode, 20 GHz)

<Example 10>

Synthesis of Fluorine-Containing Polyether (FPPFH-TMPBP)

A polyether was synthesized by performing polymerization at 190°C for 24 hours using 4,4'-dihydroxy-2,2',3,3',5,5'-hexamethylbiphenyl (TMPBP) in place of 4,4-dihydroxybiphenyl (BP) in Example 8.

Yield of polymer: 76%
Logarithmic viscosity ($\eta_{inh}$): 0.47 dL/g (0.5 g/dL concentration solution in NMP, measured at 30°C)
Number average molecular weight (Mn): 50,000, Molecular weight distribution (Mw/Mn): 2.4
This polymer was dissolved in THF to prepare a transparent cast film (film thickness 60 $\mu$m).
FT-IR (film, $cm^{-1}$): 1600 (C=C), 1504 (C=C), 1292-1143 (C-F)
Elemental analysis ($C_{36}H_{28}O_2F_{12}$):

Calculated value C, 60.00%; H, 3.92%
Measured value C, 60.22%; H, 3.98%

Solubility: soluble to NMP, TMU, DMI, DMAc, THF, chloroform, ethyl acetate, cyclohexanone, and cyclopentanone
5% Weight loss temperature: 415°C (in air), 432°C (in nitrogen)
10% Weight loss temperature: 439°C (in air), 446°C (in nitrogen)
Carbonization yield: 52% (in nitrogen, 800°C)
Glass transition temperature (Tg): 167°C (DSC), 169°C (TMA), 166°C (DMA)
Coefficient of thermal expansion (CTE): 82 ppm/°C (50°C to 80°C)
Tensile strength at break: 48 MPa
Elongation at break: 4.3%
Tensile elasticity: 1.3 GPa
Cut-off wavelength: 308 nm
Transmission at 500 nm: 57%,
Average refractive index ($n_{ave}$): 1.552 (d line)
Birefringence ($\Delta n$): 0.006 (d line)
Dielectric constant ($\varepsilon$) calculated from refractive index: 2.32 ($\varepsilon = n_{ave}^2$)
Dielectric constant (Dk): 2.39 (TE mode, 10 GHz), 2.33 (TE mode, 20 GHz)
Dielectric dissipation factor (Df): 0.0015 (TE mode, 10 GHz), 0.0016 (TE mode, 20 GHz)

<Example 11>

Synthesis of Fluorine-Containing Polyether (FPPFH-BisTMP)

A polyether was synthesized by performing polymerization at 170°C for 12 hours using 4,4-dihydroxytetraphenylmethane (BisTMP) in place of 4,4-dihydroxybiphenyl (BP) in Example 8.

Yield of polymer: 80%
Logarithmic viscosity ($\eta_{inh}$): 0.65 dL/g (0.5 g/dL concentration solution in NMP, measured at 30°C)
Number average molecular weight (Mn): 61,000, Molecular weight distribution (Mw/Mn): 2.8

This polymer was dissolved in THF to prepare a colorless transparent cast film (film thickness 46 $\mu$m).

FT-IR (film, $cm^{-1}$): 1600 (C=C), 1504 (C=C), 1292-1143 (C-F)
Elemental analysis:

Calculated value C, 64.34%; H, 3.27%
Measured value C, 64.15%; H, 3.35%

Solubility: soluble to NMP, TMU, DMI, DMAc, and THF
5% Weight loss temperature: 498°C (in air), 508°C (in nitrogen)
10% Weight loss temperature: 514°C (in air), 520°C (in nitrogen)
Carbonization yield: 57% (in nitrogen, 800°C)
Glass transition temperature (Tg): 133°C (DSC), 143°C (TMA), 135°C (DMA)
Coefficient of thermal expansion (CTE): 70 ppm/°C (50°C to 80°C)
Tensile strength at break: 46 MPa
Elongation at break: 3.2%
Tensile elasticity: 1.5 GPa
Cut-off wavelength: 292 nm
Transmission at 500 nm: 79%,
Average refractive index ($n_{ave}$): 1.566 (d line)
Birefringence ($\Delta n$): 0.008 (d line)
Dielectric constant ($\varepsilon$) calculated from refractive index: 2.45 ($\varepsilon = n_{ave}^2$)
Dielectric constant (Dk): 2.45 (TE mode, 10 GHz), 2.44 (TE mode, 20 GHz)
Dielectric dissipation factor (Df): 0.0036 (TE mode, 10 GHz), 0.0038 (TE mode, 20 GHz)

<Example 12>

Synthesis of Fluorine-Containing Polyether (FPPFH-TBISRX)

A polyether was synthesized by performing polymerization at 190°C for 4 hours using spiro[fluorene-9,9'-xanthene]-3',6'-diol (TBISRX) in place of 9,9-bis(4-hydroxyphenyl)fluorene (BPFL) in Example 6.

Yield of polymer: 81%
Logarithmic viscosity ($\eta_{inh}$): 0.81 dL/g (0.5 g/dL concentration solution in NMP, measured at 30°C)
Number average molecular weight (Mn): 94,000, Molecular weight distribution (Mw/Mn): 2.9

This polymer was dissolved in chloroform to prepare a colorless transparent cast film (film thickness 50 $\mu$m).

FT-IR (film, $cm^{-1}$): 1600 (C=C), 1504 (C=C), 1292-1143 (C-F)
Elemental analysis:

Calculated value C, 63.40%; H, 2.72%
Measured value C, 63.69%; H, 2.89%

Solubility: soluble to NMP, TMU, DMI, DMAc, DMF, THF, chloroform, ethyl acetate, cyclohexanone, and cyclopentanone
5% Weight loss temperature: 507°C (in air), 545°C (in nitrogen)

10% Weight loss temperature: 525°C (in air), 561°C (in nitrogen)
Carbonization yield: 60% (in nitrogen, 800°C)
Glass transition temperature (Tg): 190°C (DSC), 205°C (TMA), 189°C (DMA)
Coefficient of thermal expansion (CTE): 65 ppm/°C (50°C to 80°C)
Tensile strength at break: 58 MPa
Elongation at break: 5.8%
Tensile elasticity: 1.2 GPa
Cut-off wavelength: 315 nm
Transmission at 500 nm: 86%,
Average refractive index ($n_{ave}$): 1.579 (d line)
Birefringence ($\Delta n$): 0.003 (d line)
Dielectric constant ($\varepsilon$) calculated from refractive index: 2.49 ($\varepsilon = n_{ave}^2$)
Dielectric constant (Dk): 2.46 (TE mode, 10 GHz), 2.44 (TE mode, 20 GHz)
Dielectric dissipation factor (Df): 0.0014 (TE mode, 10 GHz), 0.0015 (TE mode, 20 GHz)

<Example 13>

Synthesis of Fluorine-Containing Polyether (FPPFB-BisA)

A polyether was synthesized by performing polymerization at 190°C for 3 hours using 1,4-bis(4-fluorophenyl)perfluorobutane (FPPFB) in place of FPPFH in Comparative Example 1.

Yield of polymer: 80%
Logarithmic viscosity ($\eta_{inh}$): 1.06 dL/g (0.5 g/dL concentration solution in NMP, measured at 30°C)
Number average molecular weight (Mn): 119,000, Molecular weight distribution (Mw/Mn): 2.5
This polymer was dissolved in chloroform to prepare a colorless transparent cast film (film thickness 48 $\mu$m).
FT-IR (film, $cm^{-1}$): 1600 (C=C), 1502 (C=C), 1287-1139 (C-F)
Elemental analysis ($C_{31}H_{22}O_2F_8$):

Calculated value C, 64.36%; H, 3.83%
Measured value C, 64.72%; H, 3.87%

Solubility: soluble to NMP, TMU, DMI, DMAc, THF, chloroform, cyclohexanone, and cyclopentanone
5% Weight loss temperature: 445°C (in air), 495°C (in nitrogen)
10% Weight loss temperature: 458°C (in air), 503°C (in nitrogen)
Carbonization yield: 60% (in nitrogen, 800°C)
Glass transition temperature (Tg): 113°C (DSC), 112°C (TMA), 111°C (DMA)
Coefficient of thermal expansion (CTE): 105 ppm/°C (50°C to 80°C)
Tensile strength at break: 35 MPa
Elongation at break: 3.7%
Tensile elasticity: 1.3 GPa
Cut-off wavelength: 289 nm
Transmission at 500 nm: 87%,
Average refractive index ($n_{ave}$): 1.556 (d line)
Birefringence ($\Delta n$): 0.004 (d line)
Dielectric constant ($\varepsilon$) calculated from refractive index: 2.42 ($\varepsilon = n_{ave}^2$)
Dielectric constant (Dk): 2.44 (TE mode, 10 GHz), 2.40 (TE mode, 20 GHz)
Dielectric dissipation factor (Df): 0.0016 (TE mode, 10 GHz), 0.0017 (TE mode, 20 GHz)

<Example 14>

Synthesis of Fluorine-Containing Polyether (FPPFB-BisAF)

A polyether was synthesized by performing polymerization at 190°C for 3 hours using 1,4-bis(4-fluorophenyl)perfluorobutane (FPPFB) in place of FPPFH in Comparative Example 2.

Yield of polymer: 76%
Logarithmic viscosity ($\eta_{inh}$): 0.80 dL/g (0.5 g/dL concentration solution in NMP, measured at 30°C)

Number average molecular weight (Mn): 86,000, Molecular weight distribution (Mw/Mn): 2.6

This polymer was dissolved in chloroform to prepare a colorless transparent cast film (film thickness 40 μm).

FT-IR (film, $cm^{-1}$): 1603 (C=C), 1507 (C=C), 1251-1138 (C-F), 1103 (C-O)
Elemental analysis ($C_{31}H_{16}O_2F_{14}$):

Calculated value C, 54.24%; H, 2.35%
Measured value C, 54.30%; H, 2.41%

Solubility: soluble to NMP, TMU, DMI, DMF, THF, chloroform, acetone, and ethyl acetate
5% Weight loss temperature: 483°C (in air), 507°C (in nitrogen)
10% Weight loss temperature: 500°C (in air), 518°C (in nitrogen)
Carbonization yield: 50% (in nitrogen, 800°C)
Glass transition temperature (Tg): 122°C (DSC), 122°C (TMA), 119°C (DMA)
Coefficient of thermal expansion (CTE): 84 ppm/°C (50°C to 80°C)
Tensile strength at break: 36 MPa
Elongation at break: 3.0%
Tensile elasticity: 2.3 GPa
Cut-off wavelength: 281 nm
Transmission at 500 nm: 85%,
Average refractive index ($n_{ave}$): 1.518 (d line)
Birefringence ($\Delta n$): 0.003 (d line)
Dielectric constant ($\varepsilon$) calculated from refractive index: 2.30 ($\varepsilon = n_{ave}^2$)
Dielectric constant (Dk): 2.21 (TE mode, 10 GHz), 2.18 (TE mode, 20 GHz)
Dielectric dissipation factor (Df): 0.0017 (TE mode, 10 GHz), 0.0019 (TE mode, 20 GHz)

<Example 15>

Synthesis of Fluorine-Containing Polyether (FPPFB-BPFL)

A polyether was synthesized by performing polymerization at 190°C for 6 hours using 1,4-bis(4-fluorophenyl)perfluorobutane (FPPFB) in place of FPPFH in Example 6.

Yield of polymer: 74%
Logarithmic viscosity ($\eta_{inh}$): 1.11 dL/g (0.5 g/dL concentration solution in NMP, measured at 30°C)
Number average molecular weight (Mn): 130,000, Molecular weight distribution (Mw/Mn): 2.5

This polymer was dissolved in chloroform to prepare a colorless transparent cast film (film thickness 46 μm).

FT-IR (film, $cm^{-1}$): 1599 (C=C), 1500 (C=C), 1286-1139 (C-F), 1104 (C-O)
Elemental analysis ($C_{41}H_{24}O_2F_8$):

Calculated value C, 70.28%; H, 3.45%
Measured value C, 70.47%; H, 3.46%

Solubility: soluble to NMP, TMU, DMI, DMAc, DMF, THF, chloroform, ethyl acetate, cyclohexanone, and cyclopentanone
5% Weight loss temperature: 507°C (in air), 533°C (in nitrogen)
10% Weight loss temperature: 518°C (in air), 547°C (in nitrogen)
Carbonization yield: 69% (in nitrogen, 800°C)
Glass transition temperature (Tg): 196°C (DSC), 194°C (TMA), 193°C (DMA)
Coefficient of thermal expansion (CTE): 72 ppm/°C (50°C to 80°C)
Tensile strength at break: 60 MPa
Elongation at break: 4.7%
Tensile elasticity: 1.6 GPa
Cut-off wavelength: 319 nm
Transmission at 500 nm: 82%,

Average refractive index ($n_{ave}$): 1.596 (d line)
Birefringence ($\Delta n$): 0.003 (d line)
Dielectric constant ($\varepsilon$) calculated from refractive index: 2.55 ($\varepsilon = n_{ave}^2$)
Dielectric constant (Dk): 2.53 (TE mode, 10 GHz), 2.49 (TE mode, 20 GHz)
Dielectric dissipation factor (Df): 0.0011 (TE mode, 10 GHz), 0.0013 (TE mode, 20 GHz)

<Example 16>

Synthesis of Fluorine-Containing Polyether (FPPFB-TBISRX)

A polyether was synthesized by performing polymerization at 190°C for 4 hours using 1,4-bis(4-fluorophenyl)perfluorobutane (FPPFB) in place of FPPFH in Example 12.

Yield of polymer: 79%
Logarithmic viscosity ($\eta_{inh}$): 0.92 dL/g (0.5 g/dL concentration solution in NMP, measured at 30°C)
Number average molecular weight (Mn): 89,000, Molecular weight distribution (Mw/Mn): 2.4
This polymer was dissolved in chloroform to prepare a colorless transparent cast film (film thickness 42 $\mu$m).
FT-IR (film, $cm^{-1}$): 1602 (C=C), 1510 (C=C), 1284-1154 (C-F), 1104 (C-O)
Elemental analysis ($C_{41}H_{22}O_3F_8$):

Calculated value C, 68.91%; H, 3.10%
Measured value C, 68.90%; H, 3.15%

Solubility: soluble to NMP, TMU, DMI, DMAc, DMF, THF, chloroform, cyclohexanone, and cyclopentanone
5% Weight loss temperature: 501°C (in air), 546°C (in nitrogen)
10% Weight loss temperature: 522°C (in air), 563°C (in nitrogen)
Carbonization yield: 64% (in nitrogen, 800°C)
Glass transition temperature (Tg): 211°C (DSC), 211°C (TMA), 210°C (DMA)
Coefficient of thermal expansion (CTE): 74 ppm/°C (50°C to 80°C)
Tensile strength at break: 59 MPa
Elongation at break: 4.5%
Tensile elasticity: 2.4 GPa
Cut-off wavelength: 312 nm
Transmission at 500 nm: 83%,
Average refractive index ($n_{ave}$): 1.601 (d line)
Birefringence ($\Delta n$): 0.004 (d line)
Dielectric constant ($\varepsilon$) calculated from refractive index: 2.56 ($\varepsilon = n_{ave}^2$)
Dielectric constant (Dk): 2.54 (TE mode, 10 GHz), 2.51 (TE mode, 20 GHz)
Dielectric dissipation factor (Df): 0.0010 (TE mode, 10 GHz), 0.0012 (TE mode, 20 GHz)

<Example 17>

Synthesis of Fluorine-Containing Polyether (FPPFB-BisPCDE)

A polyether was synthesized by performing polymerization at 190°C for 5 hours using 1,4-bis(4-fluorophenyl)perfluorobutane (FPPFB) in place of FPPFH in Example 4.

Yield of polymer: 80%
Logarithmic viscosity ($\eta_{inh}$): 0.86 dL/g (0.5 g/dL concentration solution in NMP, measured at 30°C)
Number average molecular weight (Mn): 85,000, Molecular weight distribution (Mw/Mn): 2.4

This polymer was dissolved in chloroform to prepare a colorless transparent cast film (film thickness 44 $\mu$m).

FT-IR (film, $cm^{-1}$): 2938 (C-H), 2863 (C-H), 1600 (C=C), 1502 (C=C), 1286-1139 (C-F), 1103 (C-O)
Elemental analysis ($C_{40}H_{38}O_2F_8$):

Calculated value C, 68.36%; H, 5.45%
Measured value C, 68.62%; H, 5.47%

Solubility: soluble to NMP, TMU, DMI, THF, chloroform, cyclohexanone, and cyclopentanone
5% Weight loss temperature: 323°C (in air), 427°C (in nitrogen)
10% Weight loss temperature: 337°C (in air), 440°C (in nitrogen)
Carbonization yield: 44% (in nitrogen, 800°C)
Glass transition temperature (Tg): 174°C (DSC), 172°C (TMA), 171°C (DMA)
Coefficient of thermal expansion (CTE): 84 ppm/°C (50°C to 80°C)
Tensile strength at break: 60 MPa
Elongation at break: 5.8%
Tensile elasticity: 1.4 GPa
Cut-off wavelength: 292 nm
Transmission at 500 nm: 84%,
Average refractive index ($n_{ave}$): 1.547 (d line)
Birefringence ($\Delta n$): 0.004 (d line)
Dielectric constant ($\varepsilon$) calculated from refractive index: 2.39 ($\varepsilon = n_{ave}^2$)
Dielectric constant (Dk): 2.44 (TE mode, 10 GHz), 2.38 (TE mode, 20 GHz)
Dielectric dissipation factor (Df): 0.0008 (TE mode, 10 GHz), 0.0010 (TE mode, 20 GHz)

<Comparative Example 1>

Synthesis of Fluorine-Containing Polyether (FPPFH-BisA)

In a two-necked flask (50 mL) equipped with a stirring bar, a nitrogen introducing tube, a Dean-Stark trap, and a Dimroth condenser, FPPFH (0.981 g, 2.0 mmol) and 2,2-bis(4-hydroxyphenyl)propane (BisA, 0.457 g, 2.0 mmol) were placed and dissolved in distilled 1,3-dimethyl-2-imidazolidone (DMI, 5.0 mL). Thereafter, potassium carbonate (0.332 g, 2.4 mmol) and toluene (20 mL) were added thereto. The temperature of the resultant mixture was increased in stages to 150°C, and the mixture was then stirred at 150°C for 2 hours to remove water by azeotropy. Thereafter, the mixture was stirred at 170°C for 12 hours. After the mixture was left standing to cool to room temperature, a polymer was collected with methanol. The polymer was cleaned with methanol while heating, and then dried under reduced pressure at room temperature. The polymer was dissolved in chloroform, and the resultant solution was poured into a large amount of methanol to purify the polymer by reprecipitation. The polymer was dried under reduced pressure at room temperature for 10 hours.

Yield of polymer: 1.15 g (80%)
Logarithmic viscosity ($\eta_{inh}$): 0.71 dL/g (0.5 g/dL concentration solution in NMP, measured at 30°C)
Number average molecular weight (Mn): 75,000, Molecular weight distribution (Mw/Mn): 2.5

This polymer was dissolved in chloroform, and the resultant solution was cast onto a glass plate and dried at room temperature for 6 hours, subsequently at 50°C for 3 hours, and then under reduced pressure at 85°C for 3 hours to prepare a colorless transparent cast film (film thickness 52 $\mu$m).

FT-IR (film, $cm^{-1}$): 2937 (C-H), 2862 (C-H), 1600 (C=C), 1504 (C=C), 1292-1143 (C-F)
$^1$H-NMR ($CDCl_3$, ppm): 7.51 (d, 4H), 7.26 (d, 4H), 7.05 (d, 4H), 6.98 (d, 4H), 1.70 (s, 6H)
$^{13}$C-NMR ($CDCl_3$, ppm): 161.0, 153.5, 146.9, 128.8, 128.5, 123.2, 119.7, 117.7, 42.5, 31.1
$^{19}$F-NMR ($CDCl_3$, ppm): -111.0, -122.6, -123.1

Elemental analysis:

Calculated value C, 58.41%; H, 3.27%
Measured value C, 57.90%; H, 3.34%

Solubility: soluble to DMF, DMAc, NMP, TMU, DMI, THF, chloroform, ethyl acetate, cyclohexanone, and cyclopentanone at room temperature
5% Weight loss temperature: 443°C (in air), 504°C (in nitrogen)
10% Weight loss temperature: 458°C (in air), 511°C (in nitrogen)
Carbonization yield: 46% (in nitrogen, 800°C)
Glass transition temperature (Tg): 93°C (DSC), 96°C (TMA), 93°C (DMA)
Coefficient of thermal expansion (CTE): 94 ppm/°C (50°C to 80°C)
Tensile strength at break: 35 MPa

Elongation at break: 3.4%
Tensile elasticity: 1.3 GPa
Cut-off wavelength: 290 nm
Transmission at 500 nm: 88%,
Average refractive index ($n_{ave}$): 1.531 (d line)
Birefringence ($\Delta n$): 0.001 (d line)
Dielectric constant ($\varepsilon$) calculated from refractive index: 2.34 ($\varepsilon = n_{ave}^2$)
Dielectric constant (Dk): 2.42 (TE mode, 10 GHz), 2.35 (TE mode, 20 GHz)
Dielectric dissipation factor (Df): 0.0025 (TE mode, 10 GHz), 0.0027 (TE mode, 20 GHz)

<Comparative Example 2>

Synthesis of Fluorine-Containing Polyether (FPPFH-BisAF)

In a two-necked flask (50 mL) equipped with a stirring bar, a nitrogen introducing tube, a Dean-Stark trap, and a Dimroth condenser, FPPFH (0.981 g, 2.0 mmol) and 2,2-bis(4-hydroxyphenyl)hexafluoropropane (BisAF, 0.673 g, 2.0 mmol) were placed and dissolved in distilled 1,3-dimethyl-2-imidazolidone (DMI, 5.0 mL). Thereafter, potassium carbonate (0.332 g, 2.4 mmol) and toluene (20 mL) were added thereto. The temperature of the resultant mixture was increased in stages to 150°C, and the mixture was then stirred at 150°C for 2 hours to remove water by azeotropy. Thereafter, the mixture was stirred at 170°C for 12 hours. After the mixture was left standing to cool to room temperature, a polymer was collected with methanol. The polymer was cleaned with methanol while heating, and then dried under reduced pressure at room temperature. The polymer was dissolved in chloroform, and the resultant solution was poured into a large amount of methanol to purify the polymer by reprecipitation. The polymer was dried under reduced pressure at room temperature for 10 hours.

Yield of polymer: 1.14 g (69%)
Logarithmic viscosity ($\eta_{inh}$): 0.73 dL/g (0.5 g/dL concentration solution in NMP, measured at 30°C)
Number average molecular weight (Mn): 73,000, Molecular weight distribution (Mw/Mn): 2.6

This polymer was dissolved in chloroform, and the resultant solution was cast onto a glass plate and dried at room temperature for 6 hours, subsequently at 50°C for 3 hours, and then under reduced pressure at 85°C for 3 hours to prepare a colorless transparent cast film (film thickness 57 $\mu$m).

FT-IR (film, $cm^{-1}$): 1600 (C=C), 1504 (C=C), 1292-1143 (C-F)
$^1$H-NMR ($CDCl_3$, ppm): 7.58 (d, 4H), 7.41 (d, 4H), 7.13 (d, 4H), 7.04 (d, 4H)
$^{13}$C-NMR ($CDCl_3$, ppm): 159.6, 156.8, 132.1, 129.1, 129.0, 124.4, 124.3, 119.0
$^{19}$F-NMR ($CDCl_3$, ppm): -65.4, -111.2, -122.7, -123.3

Elemental analysis:

Calculated value C, 50.40%; H, 2.05%
Measured value C, 50.37%; H, 2.18%

Solubility: soluble to DMF, DMAc, NMP, TMU, DMI, THF, chloroform, ethyl acetate, cyclohexanone, cyclopentanone, and acetone at room temperature
5% Weight loss temperature: 505°C (in air), 507°C (in nitrogen)
10% Weight loss temperature: 524°C (in air), 519°C (in nitrogen)
Carbonization yield: 42% (in nitrogen, 800°C)
Glass transition temperature (Tg): 95°C (DSC), 105°C (TMA), 97°C (DMA)
Coefficient of thermal expansion (CTE): 105 ppm/°C (50°C to 80°C)
Tensile strength at break: 34 MPa
Elongation at break: 3.8%
Tensile elasticity: 1.2 GPa
Cut-off wavelength: 282 nm
Transmission at 500 nm: 89%,
Average refractive index ($n_{ave}$): 1.500 (d line)
Birefringence ($\Delta n$): 0.004 (d line)
Dielectric constant ($\varepsilon$) calculated from refractive index: 2.25 ($\varepsilon = n_{ave}^2$)

Dielectric constant (Dk): 2.15 (TE mode, 10 GHz), 2.13 (TE mode, 20 GHz)
Dielectric dissipation factor (Df): 0.0042 (TE mode, 10 GHz), 0.0043 (TE mode, 20 GHz)

## Claims

1. A fluorine-containing polyether compound comprising a repeating unit represented by formula (1):

Formula (1):

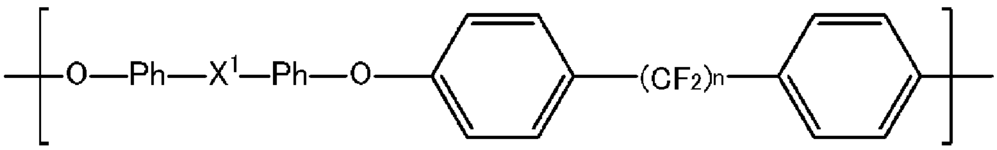

in formula (1), n represents an integer of 1 to 8, Ph represents a phenylene group, and $X^1$ represents a heterocyclic ring or a hydrocarbon ring; one or both of two phenylene groups represented by Ph, and the heterocyclic ring or the hydrocarbon ring represented by $X^1$ are optionally condensed with each other; and the phenylene group, the heterocyclic ring, and the hydrocarbon ring optionally have a substituent.

2. The fluorine-containing polyether compound according to claim 1, wherein $X^1$ represents an aromatic heterocyclic ring optionally having a substituent, an aromatic hydrocarbon ring optionally having a substituent, or an aliphatic hydrocarbon ring optionally having a substituent.

3. The fluorine-containing polyether compound according to claim 1 or 2, wherein $X^1$ represents at least one selected from the group consisting of rings represented by the following formulas:

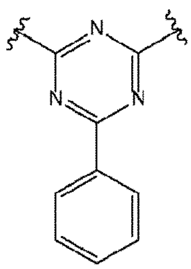
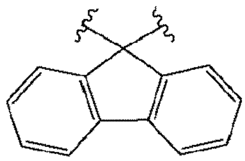
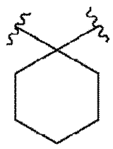
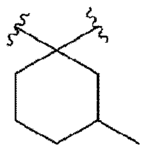
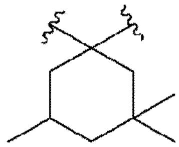
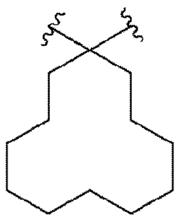
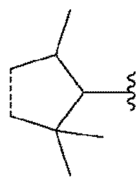

in each formula, each undulating line represents a bond position to the phenylene group represented by Ph, and a broken line represents a carbon-carbon bond shared with the phenylene group represented by Ph.

4. The fluorine-containing polyether compound according to any one of claims 1 to 3, wherein an average degree of polymerization of the repeating unit represented by formula (1) is 2 to 300.

5. A fluorine-containing polyether compound comprising a repeating unit represented by formula (2):

Formula (2):

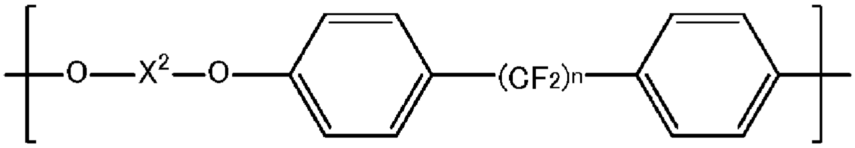

in formula (2), n represents an integer of 1 to 8, and $X^2$ represents a polycyclic aromatic hydrocarbon ring optionally having a substituent.

**6.** The fluorine-containing polyether compound according to claim 5, wherein the polycyclic aromatic hydrocarbon ring is at least one selected from the group consisting of a biphenyl ring, a terphenyl ring, a quaterphenyl ring, a naphthalene ring, an anthracene ring, a tetracene ring, and a pentacene ring.

**7.** The fluorine-containing polyether compound according to claim 5 or 6, wherein an average degree of polymerization of the repeating unit represented by formula (2) is 2 to 300.

**8.** A low dielectric material comprising the fluorine-containing polyether compound according to any of one of claims 1 to 7.

**9.** A semiconductor package substrate, a flexible printed circuit board, or a rigid printed circuit board comprising the fluorine-containing polyether compound according to any one of claims 1 to 7.

## INTERNATIONAL SEARCH REPORT

International application No.
**PCT/JP2022/019868**

**A. CLASSIFICATION OF SUBJECT MATTER**

***C08G 65/40***(2006.01)i; ***H05K 1/03***(2006.01)i
FI: C08G65/40; H05K1/03 610H; H05K1/03 670

According to International Patent Classification (IPC) or to both national classification and IPC

**B. FIELDS SEARCHED**

Minimum documentation searched (classification system followed by classification symbols)

C08G65/40; H05K1/03

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | CN 106816617 A (TORAY ADVANCED MAT RES LABORATORIES (CHINA) CO LTD) 09 June 2017 (2017-06-09) paragraph [0051] | 1, 4, 8 |
| A | | 2, 3, 5-7, 9 |
| X | JP 2006-45512 A (SUMITOMO CHEMICAL CO LTD) 16 February 2006 (2006-02-16) paragraph [0046] | 5-8 |
| A | | 1-4, 9 |
| A | JP 7-118382 A (RES DEV CORP OF JAPAN) 09 May 1995 (1995-05-09) | 1-9 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **11 July 2022** | **26 July 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/019868**

| Patent document cited in search report | Publication date (day/month/year) | Patent family member(s) | Publication date (day/month/year) |
|---|---|---|---|
| CN 106816617 A | 09 June 2017 | (Family: none) | |
| JP 2006-45512 A | 16 February 2006 | US 2005/0287410 A1<br>paragraph [0093] | |
| JP 7-118382 A | 09 May 1995 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- Perfluoroalkylene-Activated Poly(aryl ether) Synthesis. **JEFF W. LABADIE et al.** Macromolecules. American Chemical Society, 1990, vol. 23, 5371-5373